# EUROPÄISCHE PATENTSCHRIFT

(11) **EP 3 433 912 B1**
(45) Veröffentlichungstag und Bekanntmachung des Hinweises auf die Patenterteilung: **11.08.2021**
(21) Anmeldenummer: 17724741.8
(22) Anmeldetag: 19.04.2017
(51) Int. Cl.: H02B 1/01

(54) **FLACHTEILHALTER FÜR DIE BEFESTIGUNG EINES FLACHTEILS AN EINEM RAHMENGESTELL EINES SCHALTSCHRANKS UND EIN ENTSPRECHENDER SCHALTSCHRANK**
A FLAT PART HOLDER FOR FASTENING A FLAT PART TO A FRAME OF AN ELECTRICAL CABINET AND CORRESPONDING ELECTRICAL CABINET
UN SUPPORT DE PIÈCE PLATE POUR FIXER UNE PIÈCE PLATE À UN CADRE D'UNE ARMOIRE ÉLECTRIQUE ET ARMOIRE ÉLECTRIQUE CORRESPONDANTE

(30) Priorität: 27.06.2016 DE 102016111702
(43) Veröffentlichungstag der Anmeldung: 30.01.2019
(73) Patentinhaber: Rittal GmbH & Co. KG, 35745 Herborn (DE)
(72) Erfinder: REUTER, Wolfgang, 56479 Liebenscheid (DE)
(74) Vertreter: Angerhausen, Christoph
(86) Internationale Anmeldenummer: PCT/DE2017/100313
(87) Internationale Veröffentlichungsnummer: WO 2018/001406

(56) Entgegenhaltungen:
- CH-A- 348 192
- DE-C1- 10 149 599
- FR-A5- 2 097 543
- US-A- 6 012 791
- US-B2- 7 789 606
- Rittal: "Rittal Handbuch 33 Ausgabe 2011/2012", , 31 December 2011 (2011-12-31), page 665, XP055722682, Retrieved from the Internet: URL:https://www.rittal.com/de-de/content/d e/webspecial/handbuch33.jsp [retrieved on 2020-08-14]

## Beschreibung

Die Erfindung geht aus von einem Flachteilhalter für die Befestigung eines Flachteils an einem Rahmengestell eines Schaltschranks, wobei der Flachteilhalter eine offene Spange ist, die zwei gegeneinander verspannbare freie Steckabschnitte für den Eingriff in eine Ausnehmung eines Rahmengestells aufweist, wobei die Steckabschnitte über einen einen Gewindedurchgang aufweisenden Befestigungsflansch für ein Flachteil miteinander verbunden sind, wobei der Befestigungsflansch unter einem Abstand zu einem der Steckabschnitte und der Gewindedurchgang fluchtend zu diesem Steckabschnitt angeordnet ist, so dass eine durch den Gewindedurchgang eingeschraubte Schraube auf den mit dem Gewindedurchgang fluchtenden Steckabschnitt trifft und somit die Steckabschnitte gegeneinander verspannt, wobei der mit dem Gewindedurchgang fluchtende Steckabschnitt über einen gekrümmten Spannabschnitt mit dem Befestigungsflansch verbunden ist und an seinem von dem gekrümmten Spannabschnitt abgewandten Ende eine freie Stecknase für den Eingriff in ein Rahmengestell aufweist. Ein derartiger Flachteilhalter ist aus dem Rittal Handbuch, 33. Ausgabe, Seiten 95 und 665 bekannt. Ähnliche Flachteilhalter beschreiben auch die FR 2 097 543 A5, die US 7,789,606 B2, die DE 198 01 720 C1, die DE 195 25 881 C1, die DE 103 28 403 A1 und die DE 195 25 851 C1.

Die aus dem Stand der Technik bekannten Flachteilhalter haben den Nachteil, dass sie vergleichsweise aufwendig aufgebaut und damit kostenintensiv in der Herstellung und darüber hinaus aufwendig in der Anwendung sind. Häufig ist es für die Befestigung eines Flachteils am Rahmengestell eines Schaltschranks erforderlich, dass der Flachteilhalter in einem ersten Schritt an dem Rahmengestell verschraubt wird, wobei in der Regel für die Befestigung eines Flachteils gleich mehrere Flachteilhalter erforderlich sind, und erst nach der Vormontage der Flachteilhalter am Rahmengestell das Flachteil an den Flachteilhaltern und damit am Rahmengestell verschraubt werden kann.

Es ist daher die Aufgabe der Erfindung, einen Flachteilhalter der eingangs beschriebenen Art derart weiter zu entwickeln, dass er kostengünstig in der Herstellung und einfach in der Anwendung ist.

Diese Aufgabe wird durch einen Flachteilhalter mit den Merkmalen des Anspruchs 1 gelöst. Der nebengeordnete Anspruch 6 beschreibt einen entsprechenden Schaltschrank. Vorteilhafte Ausführungsformen sind Gegenstand der abhängigen Ansprüche.

Demgemäß ist vorgesehen, dass die Stecknase von einer Aufstandsseite des von dem gekrümmten Spannabschnitt abgewandten Endes des mit dem Gewindedurchgang fluchtenden Steckabschnitts vorspringt und die Aufstandsseite eine Zahnung oder Kontaktkrallen aufweist.

Durch die Ausbildung des Flachteilhalters als eine Spange kann der Flachteilhalter beispielsweise als ein einfaches Blechformteil ausgebildet werden. Der Flachteilhalter kann jedoch auch aus einem elektrisch leitfähigen Kunststoff hergestellt werden. Der Flachteilhalter kann insbesondere einteilig und/oder vollständig aus demselben Material ausgebildet werden. Dies senkt die Produktionskosten des Flachteilhalters. Die Ausbildung als Spange ermöglicht es weiterhin, dass der Flachteilhalter durch einfaches Einstecken beziehungsweise Einklipsen in vorhandene Ausnehmungen einer Profilstrebe eines Rahmengestells verliersicher an dem Rahmengestell vormontiert werden kann, mithin kann die Vormontage des Flachteilhalters am Rahmengestell werkzeuglos erfolgen. Durch das Verschrauben des Flachteils mit dem Flachteilhalter über den Gewindedurchgang, der beispielsweise als Gewindedurchzug oder Einschweißmutter ausgebildet sein kann, wird der Flachteilhalter verspannt, so dass eine feste Verbindung zwischen dem Rahmengestell, dem Flachteilhalter und dem Flachteil ausgebildet wird.

Der mit dem Gewindedurchgang fluchtende Steckabschnitt kann eine freie Fläche für eine durch den Gewindedurchgang eingeschraubte Schraube aufweisen, die zumindest in einem relaxierten Zustand des Flachteilhalters, oder wenn der Flachteilhalter an einem Vertikalprofil vormontiert ist, das heißt noch keine Befestigungsschraube in den Flachteilhalter eingedreht ist, unparallel und vorzugsweise unter einem Winkel zwischen 10° und 60° und besonders bevorzugt unter einem Winkel zwischen 20° und 50° zu dem Befestigungsflansch verläuft.

Der weitere Steckabschnitt kann an seinem von dem Montageflansch abgewandten Ende an einer Außenseite des Flachteilhalters einen Haken aufweisen. Der Haken kann dazu eingerichtet sein, eine Umrandung der Ausnehmung, über die der weitere Steckabschnitt in das Rahmengestell eingreift, zu hintergreifen. Der Haken kann dazu zu der Außenseite des Flachteilhalters hin offen sein. Der Flachteilhalter kann ausschließlich aus einem einteilig ausgeführten Formteil, insbesondere einem einteilig ausgeführten Blechformteil bestehen. Der Flachteilhalter kann beispielsweise ein gekantetes Blechformteil sein, bei dem der Gewindedurchgang als ein Gewindedurchzug ausgebildet ist. Zur Regulierung des elastischen Verhaltens des Flachteilhalters kann das Blechformteil mindestens einen Ausschnitt aufweisen. Beispielsweise kann der gekrümmte Spannabschnitt ein Abschnitt des Blechformteils sein, der mindestens eine Materialausnehmung aufweist, so dass der Flachteilhalter im Bereich des Spannabschnitts ein im Vergleich zu den übrigen Abschnitten des Flachteilhalters geringeres Biegemoment aufweist. Dadurch kann die Verformung des Flachteilhalters während des Vorspannens des Flachteilhalters durch das Einschrauben einer Schraube in den Gewindedurchgang reguliert werden.

Beispielsweise kann der Spannabschnitt dazu ausgerichtet sein, im Wesentlichen die gesamte Verformung des Flachteilhalters im Zuge des Verspannens des Flachteilhalters aufzunehmen. Insbesondere kann der Spannabschnitt dazu eingerichtet sein, dass er zugunsten des Befestigungsflansches im Wesentlichen sämtliche Deformationen des Flachteilhalters im Zuge des Verspannens aufnimmt, so dass der Befestigungsflansch unabhängig von dem Verspannungszustand des Flachteilhalters stets eine ebene Montageseite für ein Flachteil bereitstellt.

Der Gewindedurchgang kann beispielsweise ein Gewindedurchzug durch den Befestigungsflansch oder eine in einer Durchgangsöffnung durch den Befestigungsflansch festgelegte Einpressmutter oder Einschweißmutter sein. Grundsätzlich soll die Ausbildung des Gewindedurchgangs durch den Befestigungsflansch jedoch auf keine bestimmten Ausführungsformen beschränkt sein.

Gemäß einem anderen Aspekt betrifft die Erfindung einen Schaltschrank mit einem Rahmengestell aus als Hohlprofile ausgebildeten Vertikalstreben und Horizontalstreben, an dem mindestens ein Flachteil an einer Außenseite des Rahmengestells über einen Flachteilhalter der zuvor beschriebenen Art festgelegt ist. Die Horizontal- und Vertikalstreben können insbesondere als identische Streben, das heißt als Streben mit identischem Querschnitt ausgebildet sein. Lediglich beispielhaft können die Profilstreben eine der Geometrien aufweisen, die in der DE 10 2014 101 404 A1 offenbart sind. Vorteilhaft sind insbesondere Profilstreben, welche eine gegenüber einer äußeren Dichtebene des Rahmengestells zurückversetzte Montageebene aufweisen, so dass der Flachteilhalter in dem zwischen der Dichtebene und der Montageebene gebildeten Aufnahmeraum aufgenommen und von der Außenseite des Rahmengestells an das Rahmengestell angesetzt werden können. Die Dichtebene wird gerade von einer äußeren Dichtkante der Profilstreben des Rahmengestells gebildet, wobei die Dichtkante an einem Dichtelement an der Innenseite eines Flachteils zur Anlage kommt und dieses gegebenenfalls komprimiert, wenn das Flachteil an dem Rahmengestell verschraubt wird.

Mindestens eine der Vertikal- und Horizontalstreben kann zwei sich unter einem Winkel, insbesondere sich unter einem 90°-Winkel zueinander erstreckende und vorzugsweise ineinander übergehende Profilseiten aufweisen. Ein erster der Steckabschnitte kann in eine erste der beiden Profilseiten und ein zweiter der Steckabschnitte in eine zweite der beiden Profilseiten eingreifen.

Die Profilstreben können insbesondere eine Systemlochung mit einer Anordnung aus regelmäßig beabstandeten Ausnehmungen aufweisen, wobei der Flachteilhalter gerade über die Ausnehmungen der Systemlochung in die Profilstrebe eingreift. Eine erste der beiden Profilstreben kann dazu eine Anordnung aus Ausnehmungen für den Innenausbau des Schaltschranks aufweisen, wobei eine zweite der Profilseiten mit einer weiteren Profilseite, die über eine eine mindestens 180° umfassende Richtungsänderung aufweisende Umkantung in die zweite Profilseite übergeht, eine Dichtkante für die Abdichtung des Flachteils gegenüber dem Rahmengestell bildet.

Wie bereits beschrieben wurde, kann das Flachteil über eine in den Gewindedurchgang eingeschraubte Schraube mit dem Flachteilhalter verbunden sein. Dabei kann die Schraube eine Ringschneide für die elektrische Kontaktierung des Gewindedurchgangs und an ihrem dem Flachteil zugewandten Schraubenkopf eine Zahnung für die elektrische Kontaktierung des Flachteils aufweisen.

Der Schaltschrank kann weiterhin ein Montagechassis für den Innenausbau des Schaltschranks aufweisen, wobei eine der beiden Profilseiten eines Vertikal- oder Horizontalprofils des Rahmengestells eine Anordnung aus Ausnehmungen aufweist und das Montagechassis über seinen Befestigungsflansch auf der die Ausnehmungen aufweisenden Profilseite montiert ist. Eine derartige Anordnung ist aus der DE 10 2014 101 404 A1 bekannt. Für die Verwendung des beschriebenen Flachteilhalters kann nunmehr vorgesehen sein, dass der Befestigungsflansch einen Ausschnitt aufweist, in dem der in die Profilseite eingreifende Steckabschnitt aufgenommen ist. Alternativ oder zusätzlich kann vorgesehen sein, dass der Befestigungsflansch mindestens einen Durchlass aufweist, der mit einer der Ausnehmungen fluchtet, wobei der Flachteilhalter mit dem in die erste Profilseite eingreifenden Steckabschnitt durch den Durchlass hindurch in die erste Profilseite eingreift, und wobei der in die erste Profilseite eingreifende Steckabschnitt Kontaktzähne aufweist, mit denen er eine Berandung des Durchlasses elektrisch kontaktiert.

Der Flachteilhalter kann insbesondere für eine Befestigung über eine Rasterlochung, insbesondere eine Systernlochung der Profilstreben eines Rahmengestells eines Schaltschranks ohne die Verwendung von Befestigungsmitteln wie Schrauben eingerichtet sein. Weiterhin kann der Flachteilhalter als ein Gleichteil universell für die Befestigung von Seitenwänden, Rückwänden und Dachflächen eines Schaltschranks verwendet werden, so dass ein einziges Gleichteil für sämtliche Befestigungen von Flachteilen beziehungsweise Beplankungsteilen am Rahmengestell vorgesehen ist. Durch die Verwendung der Rasterlochung für die Montage des Flachteilhalters kann erreicht werden, dass die Montagepositionen des Flachteilhalters eindeutig vorgegeben sind, wodurch die Montage der Flachteile an dem Rahmengestell weiter erleichtert wird. Wie zuvor gezeigt wurde, erlaubt der erfindungsgemäße Flachteilhalter Ausführungsformen, welche die Montage des Halters am vollständig ausgerüsteten Schaltschranks ermöglichen, das heißt insbesondere auch dann, wenn bereits ein Chassis auf einer der Montageebenen, über die der Flachteilhalter ebenso festgelegt werden soll, eingebaut ist. Es wurde ebenso gezeigt, dass der Flachteilhalter Ausführungsformen ermöglicht, bei denen trotz des konstruktiv einfachen Aufbaus des Flachteilhalters immer noch ein wirksamer Potentialausgleich zwischen den Flachteilen und dem Rahmengestell des Schaltschranks gewährleistet ist.

Weitere Einzelheiten der Erfindung werden anhand der nachstehenden Figuren erläutert. Dabei zeigt:
- Figur 1: in perspektivischer Darstellung eine Ausführungsform eines Flachteilhalters;
- Figur 2: in perspektivischer Darstellung eine Anordnung aus einer Profilstrebe und einem daran vormontierten Flachteilhalter gemäß einem Beispiel, das nicht Teil der Erfindung ist;
- Figur 3: in perspektivischer Darstellung eine Anordnung aus einer Profilstrebe und daran vormontiertem Flachteilhalter und Montagechassis gemäß einem Beispiel, das nicht Teil der Erfindung ist;

- Figur 4: in perspektivischer Darstellung eine Anordnung aus einer Profilstrebe mit daran vormontiertem Flachteilhalter und Montagechassis gemäß einem weiteren Beispiel, das nicht Teil der Erfindung ist;

- Figur 5: eine Detailansicht eines Horizontalquerschnitts eines Schaltschranks im Eckbereich, mit zwei über einen Flachteilhalter an dem Rahmengestell festgelegten Flachteilen, nicht Teil der Erfindung, und
- Figur 6: in perspektivischer Darstellung eine weitere Ausführungsform eines Flachteilhalters.

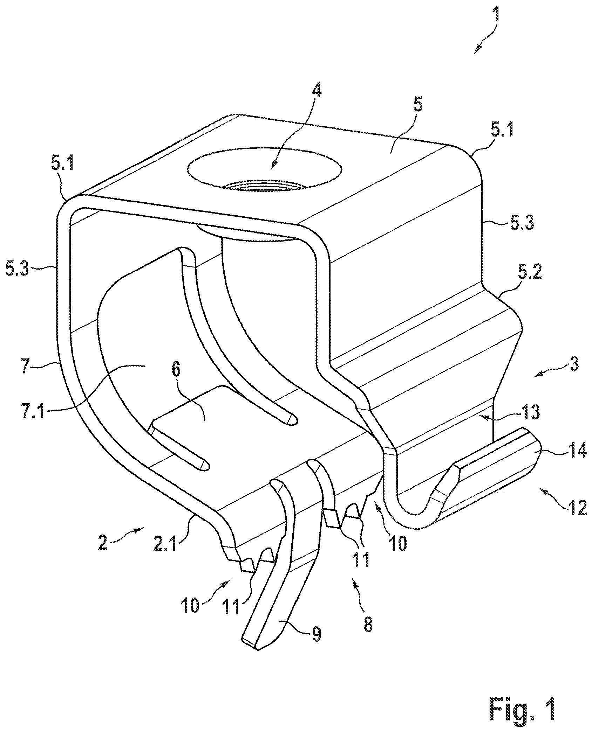

Die Figur 1 zeigt eine beispielhafte Ausführungsform eines Flachteilhalters 1. Dieser ist als Blechformteil ausgebildet, bei dem die verschiedenen Flachteilhalterseiten über Abkantungen ineinander übergehen. Der Flachteilhalter 1 ist erkennbar einteilig ausgebildet. Der Flachteilhalter 1 weist insbesondere einen Befestigungsflansch 5 mit einem Gewindedurchgang 4 auf, der als ein Gewindeauszug ausgebildet ist. Über 90°-Umkantungen 5.1, die an gegenüber liegenden Seiten des Befestigungsflansches 5 in den Befestigungsflansch 5 übergehen, sind parallel beabstandet Verbindungsabschnitte 5.3 an den Befestigungsflansch 5 angeformt. Einer der Verbindungsabschnitte 5.3 geht in einen Spannabschnitt 7 über, an dessen von dem Verbindungsabschnitt 5.3 abgewandten Ende der erste Steckabschnitt 2 angeformt ist. Der andere Verbindungsabschnitt 5.3 verbindet den Befestigungsflansch 5 mit dem zweiten Steckabschnitt 3, wobei zwischen dem Verbindungsabschnitt 5.3 und dem zweiten Steckabschnitt 3 eine Kröpfung 5.2 ausgebildet ist. An dem freien Ende des zweiten Steckabschnitts 3 ist an der Außenseite 13 des Flachteilhalters 1 ein Haken 14 ausgebildet. Der Haken 14 ist in seinen Abmessungen darauf ausgerichtet, formschlüssig in eine Ausnehmung in einem Rahmenprofil eines Schaltschranks (nicht dargestellt) einzugreifen und eine Berandung der Ausnehmung zu hintergreifen.

Der Spannabschnitt 7 weist einen Ausschnitt 7.1 auf. Dadurch kann der Spannabschnitt 7 beim Verspannen des Flachteilhalters 1 zumindest wesentliche Teile der Verformung des Flachteilhalters 1 aufnehmen.

Fluchtend mit dem Gewindedurchzug 4 ist eine Prallfläche 6 des ersten Steckabschnitts 2 angeordnet, so dass eine über den Gewindedurchzug 4 in den Flachteilhalter 1 eingeschraubte Schraube ab einer bestimmten Einschraubtiefe auf die Prallfläche 6 trifft und durch weiteres Einschrauben den Flachteilhalter 1, insbesondere die beiden Steckabschnitte 2, 3 zueinander verspannt, wobei, wie bereits beschrieben, ein wesentlicher Teil des auf den Halter 1 über die Schraube ausgeübten Biegemoments von dem Spannabschnitt 7 aufgenommen wird.

An einem freien Ende des ersten Steckabschnitts 2 weist der erste Steckabschnitt 2 eine Stecknase 9 auf, über die der erste Steckabschnitt 2 über eine Ausnehmung in einem Rahmenprofil in das Rahmenprofil eingreifen kann. Die die Stecknase 9 umgebende Aufstandseite 10 weist eine Zahnung 1 1 auf, über die sich der Flachteilhalter 1 durch eine etwaige Lackierung des Rahmenprofils bis auf die metallisch leitende Oberfläche des Rahmenprofils eingraben kann, so dass ein Potentialausgleich zwischen dem Flachteilhalter 1 und dem Profil hergestellt ist.

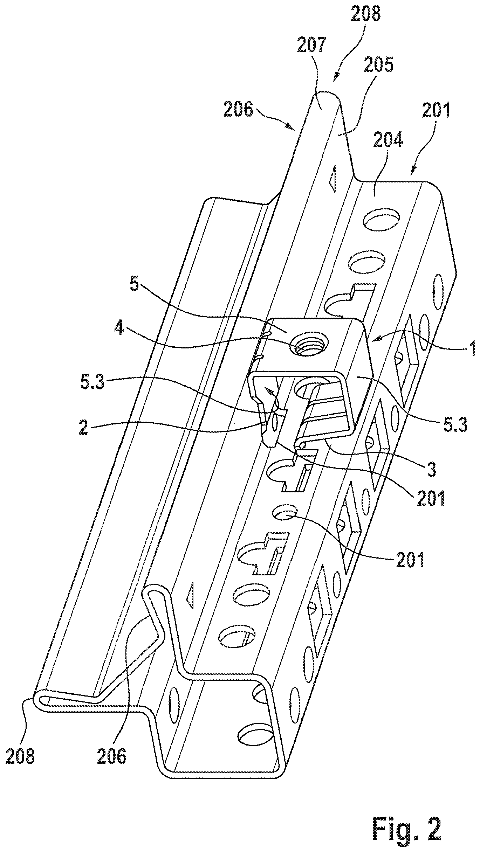

In Figur 2 ist eine Horizontal- oder Vertikalstrebe 202, 203 eines Rahmengestells 200 gezeigt, an der ein Flachteilhalter 1, nicht Teil der Erfindung, vormontiert ist. Dazu greift der Flachteilhalter 1 über seine beiden Steckenden 2, 3 in Ausnehmungen 201 der Horizontal- oder Vertikalstrebe 202, 203 ein. Die Geometrie des Halters 1 im relaxierten Zustand ist derart auf die Position und Abmessungen der Ausnehmungen 201 abgestimmt, dass der Flachteilhalter 1 unter einer Vorspannung in die Ausnehmungen 201 eingesetzt, mithin eingeklipst ist, so dass der Flachteilhalter 1 verliersicher an der Horizontal- oder Vertikalstrebe 202, 203 festgelegt ist. Die Ausnehmungen 201 können beispielsweise Bestandteil einer Systemlochung einer ersten Profilseite 204 sein, die eine Montageseite für den Innenausbau des Schaltschranks bildet. Eine zweite Profilseite 205 des Rahmenprofils erstreckt sich im Wesentlichen senkrecht zu der ersten Profilseite 204, so dass die beiden Profilseiten 204, 205 eine Aufnahme für den Flachteilhalter 1 bilden. Insbesondere kann die zweite Profilseite 205 mit einer weiteren Profilseite 206 einen Dichtsteg bilden, indem diese über eine Umkantung 207 ineinander übergehen, die beispielsweise 180°, hier sogar mehr als 180°, einschließt. Die gebildete Dichtkante 208 kann beispielsweise auf einem an der Innenseite eines Flachteils angeordneten Dichtelement, beispielsweise einer aufgeschäumten PU-Dichtungsmasse, zur Anlage kommen, um so das Flachteil gegenüber dem Rahmengestell abzudichten.

Es ist weiterhin zu erkennen, dass die Dichtkante 208 den Befestigungsflansch 5 überragt, so dass bei der Verschraubung des Flachteils (nicht dargestellt) über den Gewindedurchgang 4 des Flachteilhalters 1 die Dichtkante 208 in ein Dichtelement (nicht dargestellt) an der Innenseite des Flachteils eindringen bzw. das Dichtelement entsprechend verformen/komprimieren kann.

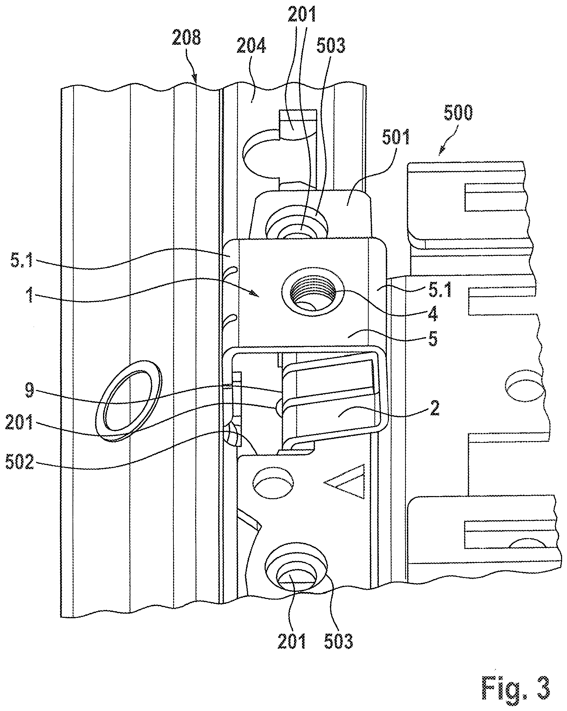

Wie in Figur 3 gezeigt ist, kann die erste Profilseite 204 der Profilstrebe eine Montageseite für den Innenausbau eines Schaltschranks sein, über die ein Montagechassis 500 an dem Rahmenprofil festgelegt werden kann. Um zu vermeiden, dass ein ebenfalls über die erste Profilseite 204 festgelegter Flachteilhalter 1 den Innenausbau des Schaltschrankinnenraums behindert, weist das Montagechassis 500 in seinem Befestigungsflansch 501 einen Ausschnitt 502 auf, so dass der Befestigungsflansch 501 den Flachteilhalter umbaut, beziehungsweise der erste Steckabschnitt durch den Befestigungsflansch 501 des Montagechassis 500 hindurchtreten kann. Für die Befestigung des Montagechassis 500 auf der ersten Profilseite 204 weist der Befestigungsflansch 501 Durchlässe 503 auf, die mit Ausnehmungen 201 der ersten Profilseite 204 fluchten und somit beispielsweise für die Hindurchführung von Schraubverbindern verwendet werden können.

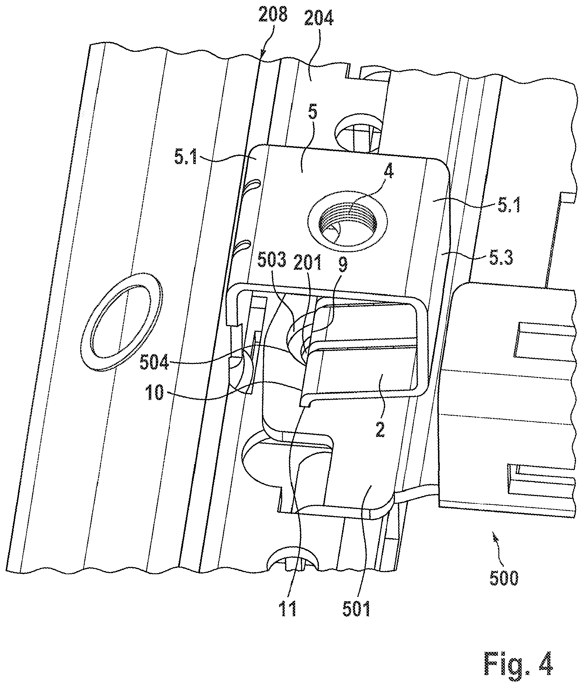

Alternativ oder ergänzend zu der Anordnung gemäß Figur 3 zeigt Figur 4 ein Beispiel, bei der der Befestigungsflansch 501 des Montagechassis 500 einen Durchlass 503 aufweist, über den der erste Steckabschnitt 2 zumindest mit seiner Stecknase 9 hindurch in die erste Profilseite 204 eingreifen kann. Der erste Steckabschnitt 2 lagert mit seiner Aufstandsseite 10, insbesondere über die daran ausgebildete Zahnung 11 auf einer Berandung 504 des Durchlasses 503, so dass ein elektrischer Potentialausgleich zwischen dem Flachteilhalter 1 und dem Montagechassis 500 gebildet ist.

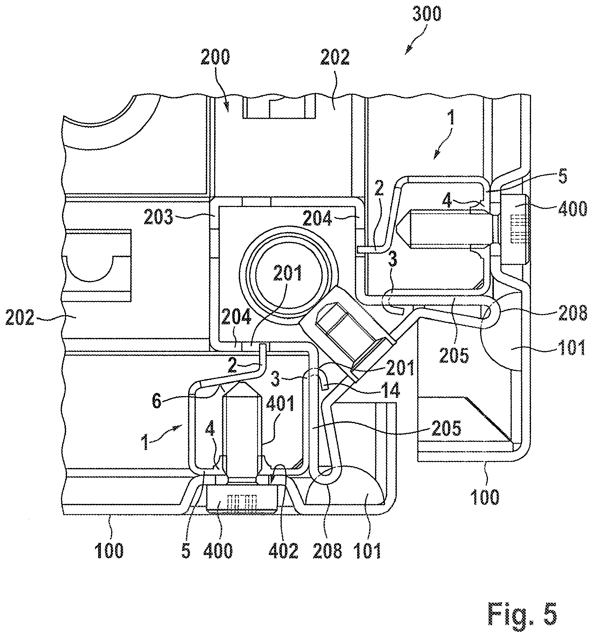

Die Figur 5 zeigt einen Schaltschrank 300 im Eckbereich, genauer einen Horizontalquerschnitt durch diesen. Es ist das Rahmengestell 200 des Schaltschranks 300 zu erkennen, welches im Eckbereich aus zwei rechtwinklig zueinander stehenden Horizontalstreben 202 und einer zu diesen senkrecht angeordneten Vertikalstrebe 203 zusammengesetzt ist. Über jeweils einen Flachteilhalter 1, der nicht Teil der Erfindung ist, sind senkrecht zueinander zwei Flachteile 100 an der Vertikalstrebe 203 festgelegt. Es ist zu erkennen, dass die Flachteilhalter 1 jeweils mit ihren Haken 14 über eine Ausnehmung in die zweiten Profilseiten 205 eingreifen und die zweiten Profilseiten 205 hintergreifen, während der erste Steckabschnitt 2 mit seinem freien Ende, das eine Stecknase 9 aufweisen kann (vergleiche Figur 1) über eine weitere Ausnehmung 201 in der ersten Profilseite 204 in das Vertikalprofil eingreift.

Die Flachteile 100 sind jeweils über eine Schraube 400 mit einer Ringschneide 401 am Außenumfang an dem Flachteilhalter 1 befestigt, wobei die Schraube 400 mit ihrer konischen Spitze auf der Prallfläche 6 des ersten Steckabschnitts 2 lagert, so dass im Zuge des Einschraubens der Schraube 400 in den Flachteilhalter 1 durch den Gewindedurchgang 4 hindurch die Steckabschnitte 2, 3 gegeneinander verspannt und damit eine feste Verbindung zwischen Flachteil 100, Flachteilhalter 1 und Vertikalprofil 203 ausgebildet wird. Die Schraube 400 weist an ihrer Schraubenkopfunterseite eine Zahnung 402 auf, so dass auch zwischen der Schraube 400 und dem Flachteil 100 ein Potentialausgleich gegeben ist. Über die Ringschneide 401 und den Gewindedurchgang 4 ist ein Potentialausgleich zwischen der Schraube 400 und dem Flachteilhalter 1 hergestellt. Der Flachteilhalter 1 stellt wiederum über seine Zahnung 11 (vergleiche Figur 1) einen Potentialausgleich zwischen sich selbst und der ersten Profilseite 204, mithin der Vertikalstrebe 203 und damit dem Rahmengestell 200 her.

Letztlich ist gezeigt, dass die Dichtkante 208 des Vertikalprofils 203 den Befestigungsflansch 5 mit dem Gewindedurchgang 4 überragt, so dass bei an dem Flachteilhalter 1 anliegendem Flachteil die Dichtkante 208 in das Dichtelement 101 an der Innenseite des Flachteils 100 eintritt beziehungsweise die Dichtung 101 komprimiert., so dass das Flachteil 100 gegenüber dem Rahmengestell 200 abgedichtet ist.

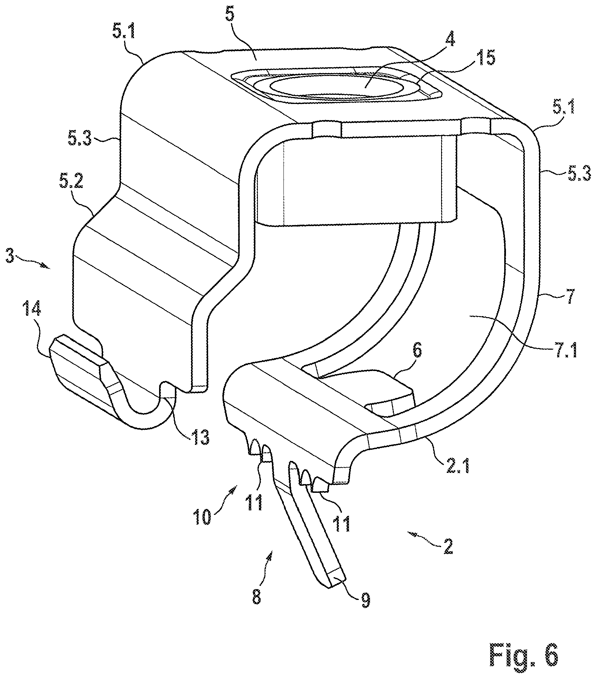

Figur 6 zeigt eine weitere Ausführungsform eines Flachteilhalters, bei dem der Gewindedurchgang 4 nicht wie bei der Ausführungsform nach Figur 1 als ein Gewindedurchzug durch den Befestigungsflansch ausgebildet ist, sondern statt dessen von einer in einer Durchgangsöffhung 15 in dem Befestigungsflansch 5 festgelegte Einpressmutter bereitgestellt ist. Die Einpressmutter ist dabei von der Unterseite des Befestigungsflansches 5 in der Durchgangsöffnung 15 des Befestigungsflansches 5 verpresst, so dass die Einpressmutter zwischen den gegenüber liegenden Verbindungsabschnitten 5.3, die über 90°-Abkantungen an den Befestigungsflansch angeformt sind, aufgenommen ist.

### Bezugszeichenliste

- 1: Flachteilhalter
- 2: Erster Steckabschnitt
- 3: Zweiter Steckabschnitt
- 4: Gewindedurchgang
- 5: Befestigungsflansch
- 5.1: 90°-Umkantung
- 5.2: Kröpfung
- 5.3: Verbindungsabschnitt
- 6: Prallfläche
- 7: Spannabschnitt
- 7.1: Ausschnitt
- 8: abgewandtes Ende
- 9: Stecknase
- 10: Aufstandsseite
- 11: Zahnung
- 12: abgewandtes Ende
- 13: Außenseite
- 14: Haken
- 15: Durchgangsöffnung
- 100: Flachteil
- 101: Dichtelement
- 200: Rahmengestell
- 201: Ausnehmung
- 202: Horizontalstrebe
- 203: Vertikalstrebe
- 204: erste Profilseite
- 205: zweite Profilseite
- 206: weitere Profilseite
- 207: Umkantung
- 208: Dichtkante
- 300: Schaltschrank
- 400: Schraube
- 401: Ringschneide
- 402: Zahnung
- 500: Montagechassis
- 501: Befestigungsflansch
- 502: Ausschnitt
- 503: Durchlass
- 504: Berandung

## Patentansprüche

1. Flachteilhalter (1) für die Befestigung eines Flachteils (100) an einem Rahmengestell (200) eines Schaltschranks (300), wobei der Flachteilhalter (1) eine offene Spange ist, die zwei gegeneinander verspannbare freie Steckabschnitte (2, 3) für den Eingriff in eine Ausnehmung (201) eines Rahmengestells (200) aufweist, wobei die Steckabschnitte (2, 3) über einen einen Gewindedurchgang (4) aufweisenden Befestigungsflansch (5) für ein Flachteil (100) miteinander verbunden sind, und wobei der Befestigungsflansch (5) unter einem Abstand zu einem der Steckabschnitte (2, 3) und der Gewindedurchgang (4) fluchtend zu diesem Steckabschnitt (2) angeordnet ist, so dass eine durch den Gewindedurchgang (4) eingeschraubte Schraube (400) auf den mit dem Gewindedurchgang (4) fluchtenden Steckabschnitt (2) trifft und somit die Steckabschnitte (2, 3) gegeneinander verspannt, wobei der mit dem Gewindedurchgang (4) fluchtende Steckabschnitt (2) über einen gekrümmten Spannabschnitt (7) mit dem Befestigungsflansch (5) verbunden ist und an seinem von dem gekrümmten Spannabschnitt (7) abgewandten Ende (8) eine freie Stecknase (9) für den Eingriff in ein Rahmengestell (200) aufweist, **dadurch gekennzeichnet, dass** die Stecknase (9) von einer Aufstandsseite (10) des von dem gekrümmten Spannabschnitt (7) abgewandten Endes (8) des mit dem Gewindedurchgang (4) fluchtenden Steckabschnitts (2) vorspringt und die Aufstandsseite (10) eine Zahnung (11) oder Kontaktkrallen für die elektrische Kontaktierung des Flachteils aufweist.

2. Flachteilhalter (1) nach Anspruch 1, bei dem der mit dem Gewindedurchgang (4) fluchtende Steckabschnitt (2) eine Prallfläche (6) für eine durch den Gewindedurchgang (4) eingeschraubte Schraube (400) aufweist, die zumindest in einem relaxierten Zustand des Flachteilhalters (1) unparallel und vorzugsweise unter einem Winkel zwischen 10° und 60° und besonders bevorzugt unter einem Winkel zwischen 20° und 50° zu dem Befestigungsflansch (5) verläuft.

3. Flachteilhalter (1) nach einem der vorangegangenen Ansprüche, bei dem der weitere Steckabschnitt (3) an seinem von dem Montageflansch (5) abgewandten Ende (12) an einer Außenseite (13) des Flachteilhalters (1) einen Haken (14) aufweist.

4. Flachteilhalter (1) nach einem der vorangegangenen Ansprüche, der ausschließlich aus einem einteilig ausgeführten Blechformteil besteht.

5. Flachteilhalter (1) nach einem der Ansprüche 1 bis 3, bei dem der Gewindedurchgang (4) ein Gewindedurchzug durch den Befestigungsflansch (5) oder eine in einer Durchgangsöffnung (15) durch den Befestigungsflansch (5) festgelegte Einpressmutter oder Einschweißmutter ist.

6. Schaltschrank (300) mit einem Rahmengestell (200) aus als Hohlprofile ausgebildeten Vertikalstreben (203) und Horizontalstreben (202), an dem mindestens ein Flachteil (100) an einer Außenseite des Rahmengestells (200) über einen Flachteilhalter (1) nach einem der vorangegangenen Ansprüche festgelegt ist.

7. Schaltschrank (300) nach Anspruch 6, bei dem mindestens eine der Vertikal- und Horizontalstreben (202, 203) zwei sich unter einem Winkel, insbesondere einem 90°-Winkel, zueinander erstreckende und vorzugsweise ineinander übergehende Profilseiten (202, 203) aufweist, wobei ein erster der Steckabschnitte (2, 3) in eine erste der beiden Profilseiten (204, 205) und ein zweiter der Steckabschnitte (2, 3) in eine zweite der beiden Profilseiten (204, 205) eingreift.

8. Schaltschrank (300) nach Anspruch 7, bei dem eine erste der beiden Profilseiten (204, 205) eine Anordnung aus Ausnehmung (201) für den Innenausbau des Schaltschranks (300) aufweist und eine zweite der Profilseiten (204, 205) mit einer weiteren Profilseite (206), die über eine eine mindestens 180° umfassende Richtungsänderung aufweisende Umkantung (207) in die zweite Profilseite übergeht, eine Dichtkante (208) für die Abdichtung des Flachteils (100) gegenüber dem Rahmengestell (200) bildet.

9. Schaltschrank (300) nach einem der Ansprüche 6 bis 8, bei dem das Flachteil (100) über eine in den Gewindedurchgang (4) eingeschraubte Schraube (400) mit dem Flachteilhalter (1) verbunden ist, wobei die Schraube (400) eine Ringschneide (401) für die elektrische Kontaktierung des Gewindedurchgangs und an ihrer dem Flachteil (100) zugewandten Schraubenkopfseite eine Zahnung (402) aufweist.

10. Schaltschrank (300) nach einem der Ansprüche 6 bis 9, der weiterhin ein Montagechassis (500) für den Innenausbau des Schaltschranks (300) aufweist, wobei eine erste der beiden Profilseiten (204, 205) eine Anordnung aus Ausnehmungen (201) aufweist und das Montagechassis (500) über seinen Befestigungsflansch (501) auf der die Ausnehmungen (201) aufweisenden Profilseite (204) montiert ist, und wobei
a) der Befestigungsflansch (501) einen Ausschnitt (502) aufweist, in dem der in die Profilseite (204) eingreifende Steckabschnitt (2) aufgenommen ist; und/oder
b) der Befestigungsflansch (501) mindestens einen Durchlass (503) aufweist, der mit einer der Ausnehmungen (201) fluchtet und der Flachteilhalter (1) mit dem in die erste Profilseite (204) eingreifenden Steckabschnitt (2) durch den Durchlass (503) hindurch in die erste Profilseite (204) eingreift, wobei der in die erste Profilseite (204) eingreifende Steckabschnitt (2) Kontaktzähne (11) aufweist, mit der er eine Berandung (504) des Durchlasses (503) elektrisch kontaktiert.

## Claims

1. A flat panel holder (1) for fastening a flat panel (100) to a frame (200) of a switch cabinet (300), wherein the flat panel holder (1) is an open clasp which has two free plug-in sections (2, 3), which can be braced against one another, for engagement in a recess (201) of a frame (200), wherein the plug-in sections (2, 3) are connected to one another via a fastening flange (5) for a flat panel (100), which fastening flange has a threaded passage (4), and wherein the fastening flange (5) is arranged at a distance from one of the plug-in sections (2, 3) and the threaded passage (4) is arranged in alignment with this plug-in section (2), so that a screw (400) screwed in through the threaded passage (4) strikes the plug-in section (2) aligned with the threaded passage (4) and thus braces the plug-in sections (2, 3) against one another, the plug-in section (2) aligned with the threaded passage (4) being connected to the fastening flange (5) via a curved clamping section (7) and having, at its end (8) facing away from the curved clamping section (7), a free plug-in lug (9) for engagement in a frame (200), **characterised in that** the plug-in lug (9) projects from a contact side (10) of the end (8), remote from the curved clamping section (7), of the plug-in section (2) aligned with the threaded passage (4), and the contact side (10) has toothing (11) or contact claws for the electrical contacting of the flat panel.

2. The flat panel holder (1) according to claim 1, wherein the plug-in section (2) aligned with the threaded passage (4) has an impact surface (6) for a screw (400) screwed in through the threaded passage (4), which surface extends at least in a relaxed state of the flat panel holder (1) non-parallel and preferably at an angle between 10° and 60° and particularly preferably at an angle between 20° and 50° to the fastening flange (5).

3. The flat panel holder (1) according to one of the preceding claims, in which the further plug-in section (3) has a hook (14) at its end (12) facing away from the mounting flange (5) on an outer side (13) of the flat panel holder (1).

4. The flat panel holder (1) according to one of the preceding claims, which consists exclusively of a sheet metal moulding made in one piece.

5. The flat panel holder (1) according to any one of claims 1 to 3, wherein the threaded passage (4) is a threaded passage through the mounting flange (5) or a press-in nut or weld-in nut fixed in a passage opening (15) through the mounting flange (5).

6. A switch cabinet (300) with a frame (200) made of vertical struts (203) and horizontal struts (202) formed as hollow sections, to which at least one flat panel (100) is fixed on an outer side of the frame (200) via a flat panel holder (1) according to one of the preceding claims.

7. The switch cabinet (300) according to claim 6, in which at least one of the vertical and horizontal struts (202, 203) has two profile sides (202, 203) extending at an angle, in particular a 90° angle, to one another and preferably merging into one another, a first of the plug-in sections (2, 3) engaging in a first of the two profile sides (204, 205) and a second of the plug-in sections (2, 3) engaging in a second of the two profile sides (204, 205).

8. The switch cabinet (300) according to claim 7, in which a first of the two profile sides (204, 205) has an arrangement of recesses (201) for the internal fitting of the switch cabinet (300) and a second of the profile sides (204, 205) forms a sealing edge (208) for sealing the flat panel (100) with respect to the frame (200) by means of a further profile side (206) which merges into the second profile side via a bend (207) having a change of direction comprising at least 180°.

9. The switch cabinet (300) according to one of the claims 6 to 8, in which the flat panel (100) is connected to the flat panel holder (1) via a screw (400) screwed into the threaded passage (4), the screw (400) having an annular cutting edge (401) for the electrical contacting of the threaded passage and, on its screw head side facing the flat panel (100), a toothing (402).

10. The switch cabinet (300) according to any one of claims 6 to 9, which further comprises a mounting chassis (500) for the internal fitting of the switch cabinet (300), wherein a first of the two profile sides (204, 205) comprises an arrangement of recesses (201) and the mounting chassis (500) is mounted via its fastening flange (501) on the profile side (204) comprising the recesses (201), and wherein
a) the fastening flange (501) has a cut-out (502) in which the plug-in section (2) engaging in the profile side (204) is accommodated; and/or
b) the fastening flange (501) has at least one passage (503) which is aligned with one of the recesses (201) and the flat panel holder (1) engages through the passage (503) into the first profile side (204) with the plug-in section (2) engaging into the first profile side (204), wherein the plug-in section (2) engaging in the first profile side (204) has contact teeth (11) with which it electrically contacts a rim (504) of the passage (503).

## Revendications

1. Support de pièce plate (1) pour la fixation d'une pièce plate (100) à un châssis (200) d'une armoire de commande (300), dans lequel le support de pièce plate (1) est une agrafe ouverte qui comprend deux portions d'emboîtement libres (2, 3) pouvant être serrées l'une contre l'autre pour un emboîtement dans un évidement (201) d'un châssis (200), dans lequel les portions d'emboîtement (2, 3) sont reliées entre elles par l'intermédiaire d'une bride de fixation (5) pour une pièce plate (100), comprenant un passage fileté (4), et dans lequel la bride de fixation (5) est disposée à une certaine distance des portions d'emboîtement (2, 3) et le passage fileté (4) est aligné avec cette portion d'emboîtement (2), de façon à ce qu'une vis (400) vissée à travers le passage fileté (4) rencontre la portion d'emboîtement (2) alignée avec le passage fileté (4) et serre ainsi les portions d'emboîtement (2, 3) l'une contre l'autre, dans lequel la portion d'emboîtement (2) alignée avec le passage fileté (4) est reliée par l'intermédiaire d'une portion de serrage incurvée (7) avec la bride de fixation (5) et comprend, au niveau de son extrémité (8) opposée à la portion de serrage incurvée (7), un embout d'emboîtement libre (9) pour l'emboîtement dans un châssis (200), **caractérisé en ce que** l'embout d'emboîtement (9) dépasse d'un côté de contact (10) de l'extrémité (8), opposée à la portion de serrage incurvée (7), de la portion d'emboîtement (2) alignée avec le passage fileté (4) et le côté de contact (10) comprend une denture (11) ou des griffes de contact pour la mise en contact électrique de la pièce plate.

2. Support de pièce plate (1) selon la revendication 1, dans lequel la portion d'emboîtement (2) alignée avec le passage fileté (4) comprend un déflecteur (6) pour une vis (400) vissée à travers le passage fileté (4), qui s'étend, au moins dans un état non relâché du support de pièce plate (1), de manière non parallèle et de préférence avec un angle entre 10° et 60° et plus particulièrement de préférence avec un angle entre 20° et 50° par rapport à la bride de fixation (5).

3. Support de pièce plate (1) selon l'une des revendications précédentes, dans lequel l'autre portion d'emboîtement (3) comprend, au niveau de son extrémité (12) opposée à la bride de montage (5), sur un côté extérieur (13) du support de pièce plate (1), un crochet (14).

4. Support de pièce plate (1) selon l'une des revendications précédentes, qui est constitué exclusivement d'une pièce façonnée en tôle.

5. Support de pièce plate (1) selon l'une des revendications 1 à 3, dans lequel le passage fileté (4) est un passage fileté à travers la bride de fixation (5) ou bien un écrou à encastrer ou un écrou à souder fixé dans une ouverture de passage (15) à travers la bride de fixation (5).

6. Armoire de commande (300) avec un châssis (200), constitué de montants verticaux (203) et de montants horizontaux (202) conçus comme des profilés creux, sur lequel est fixée au moins une pièce plate (100) sur un côté extérieur du châssis (200) par l'intermédiaire d'un support de pièce plate (1) selon l'une des revendications précédentes.

7. Armoire de commande (300) selon la revendication 6, dans laquelle au moins un des montants verticaux et horizontaux (202, 203) comprend deux côtés profilés (202, 203) formant entre eux un angle, plus particulièrement un angle de 90°, et de préférence se transformant l'un dans l'autre, dans lequel une première des portions d'emboîtement (2, 3) s'emboîte dans un premier des deux côtés profilés (204, 205) et une deuxième des portions d'emboîtement (2, 3) s'emboîte dans un deuxième des deux côtés profilés (204, 205).

8. Armoire de commande (300) selon la revendication 7, dans laquelle un premier des deux côtés profilés (204, 205) comprend une disposition constituée d'un évidement (201) pour l'aménagement interne de l'armoire de commande (300) et un deuxième des deux côtés profilés (204, 205) forme, avec un autre côté profilé (206), qui se transforme dans le deuxième côté profilé par l'intermédiaire d'un pliage (207) présentant un changement de direction d'au moins 180°, une arête d'étanchéité (208) pour l'étanchéification de la pièce plate (100) par rapport au châssis (200).

9. Armoire de commande (300) selon l'une des revendications 6 à 8, dans laquelle la pièce plate (100) est reliée par l'intermédiaire d'une vis (400) vissée dans le passage fileté (4) avec le support de pièce plate (1), dans laquelle la vis (400) comprend une arête annulaire (401) pour la mise en contact électrique du passage fileté et comprend une denture (402) au niveau de son côté de tête de vis orienté vers la pièce plate (100).

10. Armoire de commande (300) selon l'une des revendications 6 à 9, qui comprend en outre un châssis de montage (500) pour l'aménagement interne de l'armoire de commande (300), dans laquelle un premier des deux côtés profilés (204, 205) comprend une disposition constituée d'évidements (201) et le châssis de montage (500) est monté par l'intermédiaire de sa bride de fixation (201) sur le côté profilé (204) comprenant les évidements (201) et dans laquelle
a) la bride de fixation (501) présente une découpe (502) dans laquelle est logée la portion d'emboîtement (2) s'emboîtant dans le côté profilé (204) ; et/ou
b) la bride de fixation (501) comprend au moins un passage (503) qui est aligné avec un des évidements (201) et le support de pièce plate (1), avec la portion d'emboîtement (2) s'emboîtant dans le premier côté profilé (204), à travers le passage (503), dans le premier côté profilé (204), dans laquelle la portion d'emboîtement (2) s'emboîtant dans le premier côté profilé (204) comprend des dents de contact (11) avec lesquelles elle est en contact électrique avec une bordure (504) du passage (503).
